# EUROPÄISCHE PATENTSCHRIFT

(11) **EP 2 514 285 B1**
(45) Veröffentlichungstag und Bekanntmachung des Hinweises auf die Patenterteilung: **25.02.2015**
(21) Anmeldenummer: 10798029.4
(22) Anmeldetag: 10.12.2010
(51) Int. Cl.: H05K 5/00

(54) **ABSCHLUSSELEMENT FÜR EIN GEHÄUSE**
END ELEMENT FOR A HOUSING
ÉLÉMENT DE FERMETURE POUR UN BOÎTIER

(30) Priorität: 16.12.2009 DE 102009054767
(43) Veröffentlichungstag der Anmeldung: 24.10.2012
(73) Patentinhaber: Robert Bosch GmbH, 70442 Stuttgart (DE)
(72) Erfinder: NOWOTNICK, Jens, 72764 Reutlingen (DE); LIPPOK, Ralf, 71522 Backnang (DE); LAUSMANN, Matthias, 71711 Murr (DE)
(86) Internationale Anmeldenummer: PCT/EP2010/069391
(87) Internationale Veröffentlichungsnummer: WO 2011/082945

(56) Entgegenhaltungen:
- EP-A2- 0 689 374
- WO-A1-02/37702
- WO-A1-03/055289
- DE-A1- 4 443 501
- DE-A1- 10 061 613
- FR-A1- 2 865 344

## Beschreibung

Die Erfindung betrifft ein Abschlusselement für ein Gehäuse nach dem Oberbegriff des Anspruchs 1.

### Stand der Technik

Bei elektronischen Geräten werden bestückte Leiterplatten zum Schutz vor Umwelteinflüssen in einem Gehäuse untergebracht. Häufig werden entweder sogenannte Schalengehäuse oder Einschubgehäuse verwendet. Bei einem Schalengehäuse wird die bestückte Leiterplatte zwischen einer Deckelschale und einer Bodenschale platziert. Bei einem Einschubgehäuse wird die bestückte Leiterplatte in ein Gehäuse eingeschoben.

Die Bauhöhe des Gehäuses ist durch die Bauhöhe der auf der Leiterplatte angeordneten elektrischen oder elektronischen Bauteile bestimmt. Vor allem in Steuergeräten für Kraftfahrzeuge kommen große und schwere Bauteile, wie beispielsweise Elektrolyt-Kondensatoren, zum Einsatz, welche zusätzliche Halterungen benötigen um die mechanischen Anforderungen, die an das Steuergerät gestellt werden, zu erfüllen. Dadurch ist ein komplexer Aufbau des Gehäuses, eventuell mit zusätzlichen Halterungselementen nötig, was einen großen Montageaufwand bedeutet. Weiter können bestimmte Bauhöhen für das Gehäuse nicht unterschritten werden.

Aus der US 3,258,649 A ist ein elektronisches Gerät mit einem Einschubgehäuse bekannt. Das Gehäuse ist röhrenartig aufgebaut. Eine Leiterplatte wird seitlich in das Gehäuse eingeschoben, dazu weist das Gehäuse an den Seitenwänden in seinem Innenraum Stege und Nuten auf, die zur Führung und Halterung einer Leiterplatte geeignet sind. Das Gehäuse ist von beiden Seiten mit jeweils einem Abschlusselement verschlossen. Ein Stecker, welcher die Leiterplatte nach außen kontaktiert, ist in eines der Abschlusselemente integriert. Auf der Leiterplatte befinden sich große Bauteile, die die Bauhöhe des Gehäuses begrenzen.

Aus der EP 0 689 374 ist ein elektronisches Steuergerät für Kraftfahrzeuge mit einem rohrartigen Gehäuse und mit einer mechanischen Halterung für ein Leistungsbauelement bekannt.

### Offenbarung der Erfindung

Die Erfindung sieht ein Abschlusselement eines röhrenartigenGehäuses für ein elektronisches Steuergerät vor, wobei mindestens ein elektrisches und/oder elektronisches Bauteil des Steuergerätes in dem Abschlusselement angeordnet ist. Erfindungsgemäß ist in dem Gehäuse zumindest eine Leiterplatte angeordnet, die elektrische und/oder elektronische Bauteile aufweist.

Das Abschlusselement enthält erfindungsgemäß elektrische Bauteile wie beispielsweise Kondensatoren oder Spulen und/oder elektronische Bauteile wie beispielsweise Sensoreinheiten oder Leistungsbauelemente. Zusätzlich können auch mechanische Bauteile, wie beispielsweise Halterungen für elektrische und/oder elektronische Bauteile oder druckausgleichende Elemente in dem Abschlusselement des Gehäuses angeordnet sein.

Durch die Platzierung von elektrischen und/oder elektronischen Bauteilen, vor allem von solchen Bauteilen, die eine vergleichsweise große Bauhöhe aufweisen, in einem Abschlusselement, wird Platz im Gehäuse und auf der Leiterplatte eingespart. Ferner ist keine aufwändige Halterung von schweren Bauteilen innerhalb des Gehäuses mehr nötig, da solche Bauteile erfindungsgemäß im Abschlusselement gehaltert werden. Dadurch kann sowohl die Größe der Leiterplatte als auch die Bauhöhe des Gehäuses zusätzlich reduziert werden. Damit wird insgesamt eine flachere und kompaktere Bauweise eines Steuergeräts ermöglicht.

Gemäß der Erfindung sind die Bauteile so in dem Abschlusselement angeordnet, dass ihre Längsachse im Wesentlichen parallel zur Ebene der Leiterplatte verläuft. Auf diese Weise kann auch die Bauhöhe des Abschlusselements gering gehalten werden. Aber auch eine Anordnung, in der die Längsachsen der Bauteile geneigt zur Ebene der Leiterplatte verlaufen, ist möglich.

Besonders bei Bauteilen mit hoher Verlustleistung und damit sehr hoher Wärmeentwicklung ist es vorteilhaft, diese in einem Abschlusselement anzuordnen. Dadurch wird eine thermische Trennung dieser Bauteile von den restlichen, auf der Leitplatte angeordneten, Bauteilen erreicht, und damit die thermische Belastung aller Bauteile vermindert. Alternativ können wärmeempfindliche Bauteile in dem Abschlusselement angeordnet werden. Auch in diesem Fall wird eine thermische Trennung erzielt und es können kostengünstigere und kleinere Bauteile eingesetzt werden. In einer vorteilhaften Ausführung der Erfindung können zusätzlich ein oder mehrere Kühlelemente in oder an dem Abschlusselement angeordnet sein.

Elektrische oder elektronische Bauteile, die in dem Abschlusselement angeordnet sind, müssen mit der in dem Gehäuse angeordneten Leiterplatte kontaktiert werden. Besonders bevorzugt ist eine Kontaktierung über eine Direktsteckverbindung. Erfindungsgemäß ist dazu in dem Abschlusselement mindestens ein Kontaktierungselement angeordnet, das elektrisch mit der Leiterplatte kontaktiert werden kann. Die Bauteile sind mit dem Kontaktierungselement elektrisch verbunden, beispielsweise durch Schweißen oder Löten. Das Kontaktierungselement ist bevorzugt so gestaltet, dass es die Kontaktierung der Leiterplatte über eine Direktsteckverbindung ermöglicht. Bei einer Direktsteckverbindung befinden sich am Randbereich der Leiterplatte Kontaktbereiche, sogenannte "Lands". Das Kontaktierungselement weist Kontakte, beispielsweise Federkontakte, auf, die die Kontaktbereiche auf der Leiterplatte elektrisch kontaktieren, sobald das Abschlusselement auf die Leiterplatte aufgesteckt wird. Alternativ können sich Steckkontakte auf der Leiterplatte befinden, in die die Kontaktpins der Bauteile, die in dem Abschlusselement angeordnet sind, eingesteckt werden. Das Kontaktierungselement ist bevorzugt als Stanzgitter ausgebildet. Alternativ kann das Kontaktierungselement auch als Drahtkontakt, metallisiertes Kunststoffteil oder Leiterplatte ausgeführt sein.

An dem Gehäuse ist mindestens ein Stecker angeordnet, der den elektrischen Kontakt von der elektronischen Anordnung innerhalb des Gehäuses nach außen herstellt. In einer bevorzugten Ausführung der Erfindung ist der Stecker in ein Abschlusselement des Gehäuses integriert. Die elektrische Verbindung des Steckers zur Leiterplatte erfolgt vorzugsweise über eine Direktsteckverbindung. Alternativ ist es möglich, auf der Leiterplatte einen Gegenstecker, eine Messerleiste, Kontaktstifte oder ähnliches vorzusehen.

Die Erfindung ist besonders vorteilhaft für Einschubgehäuse, die insbesondere als Strangpressprofil ausgebildet sind, anwendbar. Ein derartiges Gehäuse ist besonders einfach und günstig in der Herstellung. Es ist röhrenartig, mit im Wesentlichen beliebigem Querschnitt herstellbar, und besitzt zwei stirnseitige Öffnungen, die jeweils von einem Abschlusselement verschlossen werden. Beide Abschlusselemente sind nutzbar, um dort erfindungsgemäß elektrische und/oder elektronische Bauteile eines Steuergerätes und/oder einen Stecker zur Kontaktierung einer in dem Gehäuse befindlichen Leiterplatte anzuordnen. Die Montage eines derartigen Gehäuses ist sehr einfach und kostengünstig, da die Abschlusselemente lediglich aufgeschoben werden können. Es sind weder zusätzlichen Verbindungselemente wie Schrauben oder Nieten, oder Nassprozesse notwendig.

Ein weiterer Vorteil der Erfindung zeigt sich, wenn in einem Einschubgehäuse eine Leiterplatte angeordnet ist, bei der sich auf mindestens einer Oberfläche elektronische Leistungsbauelemente befinden, die zur Entwärmung über eine Wärmeleitpaste thermisch an eine Innenfläche des Einschubgehäuses angebunden werden müssen. Die Wärmeleitpaste ist dabei auf der der Leiterplatte abgewandten Oberfläche der Leistungsbauelemente aufgebracht. Bei der Montage einer solchen Anordnung ist es wichtig, dass die Wärmeleitpaste während des Einschiebens der Leiterplatte in das Gehäuse nicht verschmiert, da sonst die Wärmeleitung von dem Leistungsbauelement zur Gehäuseinnenwand beeinträchtigt sein kann. Sind große Bauelemente erfindungsgemäß in einem Abschlusselement untergebracht, ist es beim Einschieben der Leiterplatte in das Gehäuse einfach, einen Mindestabstand zwischen der Oberfläche der Leistungsbauteile, auf die eine Wärmeleitpaste aufgebracht ist, und der Gehäusewand einzuhalten, so dass die auf der Oberfläche der Leistungsbauteile aufgebrachte Wärmeleitpaste während des Einschubvorgangs nicht verschmiert. Hat die Leiterplatte ihre endgültige Position in Einschubrichtung erreicht, kann sie abgesenkt werden und somit der thermische Kontakt von der Wärmeleitpaste zur Gehäusewand hergestellt werden.

Besonders für elektronische Steuergeräte für Kraftfahrzeuge ist es vorteilhaft, in das Abschlusselement für das Gehäuse einen Rahmen aus Metall oder Kunststoff zu integrieren. Dieser Rahmen reicht in das Gehäuse hinein und dient einerseits dazu, die Leiterplatte in dem Gehäuse zu fixieren und weiterhin als Aufnahme und Kontaktierung für die elektrischen und/oder elektronischen Bauteile, die in dem Abschlusselement angeordnet sind. Ferner kann der Rahmen als Aufnahme für eventuell vorhandene Kabelbaumstecker genutzt werden. Für den Fall, dass Leistungsbauelemente mit hoher Wärmeentwicklung in dem Abschlusselement angeordnet sind, kann der Rahmen einen Teil der Wärme aufnehmen und an das Gehäuse ableiten. Es können alternativ oder zusätzlich auch Kühlelemente an dem Rahmen angeordnet sein. Vorzugsweise sind an dem Rahmen Dichtelemente angeordnet, die die Verbindung zwischen dem Gehäuse und dem Abschlusselement nach außen abdichten und das Innere des Gehäuses vor Umwelteinflüssen schützen.

Weitere Vorteile der Erfindung ergeben sich aus den Unteransprüchen und der Beschreibung der Zeichnungen.

### Zeichnungen

Figur 1a zeigt in schematischer Darstellung einen Schnitt eines elektronischen Gerätes mit einem Einschubgehäuse mit einem Abschlusselement nach dem Stand der Technik.
Figur 1b zeigt in schematischer Darstellung einen Schnitt eines elektronischen Gerätes mit einem Einschubgehäuse mit einem Abschlusselement mit einem darin angeordneten Kondensator, der mit einer Leiterplatte verlötet ist.
Figur 1c zeigt in schematischer Darstellung einen Schnitt eines elektronischen Gerätes mit einem Einschubgehäuse mit einem Abschlusselement mit einem darin angeordneten Kondensator, der mit einer Leiterplatte über eine auf der Leiterplatte angeordnete Kontaktfeder kontaktiert ist.
Figur 1d zeigt in schematischer Darstellung einen Schnitt eines elektronischen Gerätes mit einem Einschubgehäuse mit einem Abschlusselement mit einem darin angeordneten Kondensator, der mit einer Leiterplatte über eine Direktsteckverbindung kontaktiert ist.
Figur 2a zeigt in Draufsicht einen Schnitt durch ein elektronisches Gerät mit einem Einschubgehäuse mit zwei Abschlusselementen, wobei in einem Abschlusselement Kondensatoren angeordnet sind, während das zweite Abschlusselement als Stecker dient.
Figur 2b zeigt in Draufsicht einen Schnitt durch ein elektronisches Gerät mit einem Einschubgehäuse mit zwei Abschlusselementen, wobei in einem Abschlusselement sowohl ein Kondensator, als auch ein Stecker angeordnet sind.
Figur 3 zeigt eine perspektivische Ansicht eines Einschubgehäuses und einer im Einschub begriffenen Leiterplatte mit einem Abschlusselement, an dem ein Rahmen angeordnet ist.

### Beschreibung

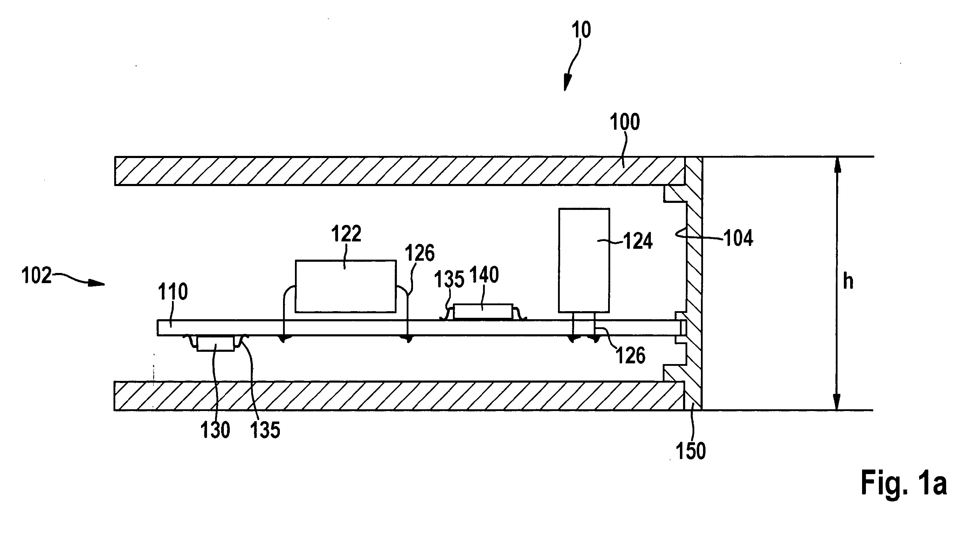

Figur 1a zeigt ein Einschubgehäuse 100 für ein Steuergerät 10. Das Gehäuse 100 ist kastenförmig aufgebaut und besitzt zwei offene Stirnflächen 102 und 104. In dem Gehäuse 100 befindet sich eine Leiterplatte 110. Auf der Oberseite und der Unterseite der Leiterplatte 110 sind elektrische und elektronische Bauteile angeordnet. Dabei handelt es sich beispielsweise um sogenannte SMD-Bauteile ("Surface-Mounted Device"), aktive oder passive elektronische Bauteile 130 und 140, die auf der Oberfläche der Leiterplatte 110 mittels Kontaktfahnen 135 kontaktiert werden. Darüber hinaus sind auf der Oberseite der Leiterplatte 110 in diesem Beispiel zwei Kondensatoren 122 und 124 angeordnet, die eine im Vergleich zu den Bauelementen 130 und 140 große Bauhöhe besitzen. Die Kondensatoren 122 und 124 sind über Anschlussdrähte 126, die durch die Leiterplatte 110 hindurchgeführt sind, auf der Rückseite der Leiterplatte 110 mit dieser verlötet. Die offene Stirnfläche 104 des Gehäuses 100 ist durch ein Abschlusselement 150 verschlossen. Die Mindestbauhöhe h des Gehäuses ist durch die Bauhöhe der Kondensatoren 122 und 124 bestimmt. Die zweite offene Stirnfläche 102 ist ferner durch ein nicht dargestelltes Steckerelement verschlossen, das den elektrischen Kontakt von der Leiterplatte 110 nach außen herstellt.

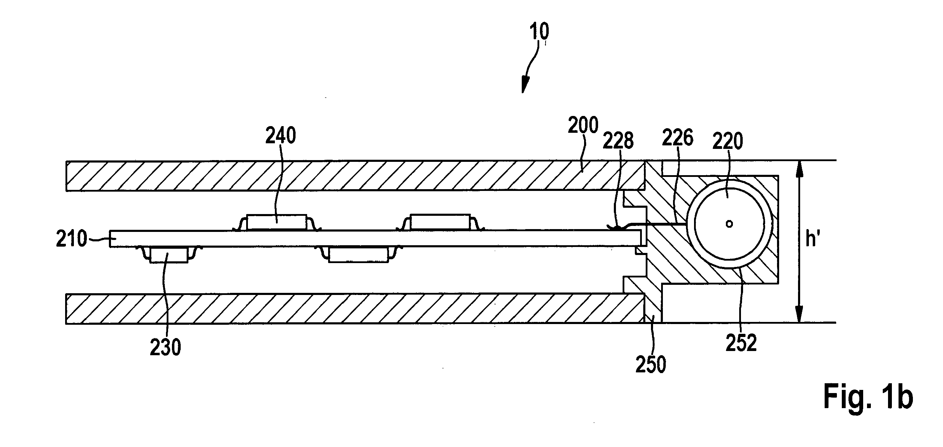

In Figur 1b ist ein Einschubgehäuse 200 dargestellt, in dem eine Leiterplatte 210 angeordnet ist. Das Gehäuse ist von einem Abschlusselement 250 verschlossen. Im Unterschied zu Figur 1a ist ein Kondensator 220 in dem Abschlusselement 250 angeordnet. Auf beiden Seiten der Leiterplatte 210 befinden sich nur noch die Bauteile 230 und 240, bei denen es sich beispielsweise um SMD-Bauteile handelt, und die eine im Vergleich zu dem Kondensator 220 geringere Bauhöhe aufweisen. Das Abschlusselement 250 weist eine Ausnehmung 252 auf, die als Halterung für den Kondensator 250 dient. Der Kondensator 220 ist so in dem Abschlusselement angeordnet, dass seine Längsachse parallel zur Ebene der Leiterplatte 210 ausgerichtet ist. Der Kondensator 220 ist über Kontaktdrähte 226, die durch das Abschlusselement 250 hindurchgeführt werden, mit der Leitplatte 210 kontaktiert, beispielsweise verlötet. Die Kontaktdrähte 226 verlaufen flach und im Wesentlichen parallel zur Leiterplatte 210 und sind an dem Abschlusselement 250 zugewandten Randbereich der Leiterplatte 210 mit dieser an der Lötstelle 228 kontaktiert. Durch eine derartige Anordnung lässt sich die Bauhöhe h' des Gehäuses 200 im Vergleich zu dem in Figur 1a dargestellten Gehäuse wesentlich verringern.

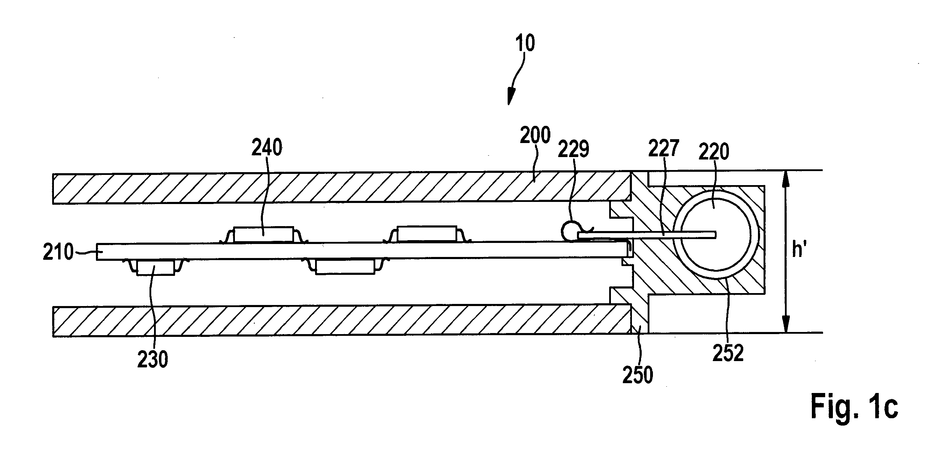

Das in Figur 1c dargestellte Einschubgehäuse entspricht im Wesentlichen dem aus Figur 1b. Gleiche Bauteile sind mit gleichen Bezugszeichen versehen. Im Unterschied zu Figur 1b ist in diesem Beispiel eine Kontaktfeder 229 an dem dem Abschlusselement 250 zugewandten Randbereich der Leiterplatte 210 angeordnet. Der Kontaktpin 227 des Kondensators 220 ist in die Kontaktfeder 229 eingesteckt. Dadurch ist der elektrische Kontakt zwischen dem Kondensator 220 und der Leiterplatte 210 hergestellt.

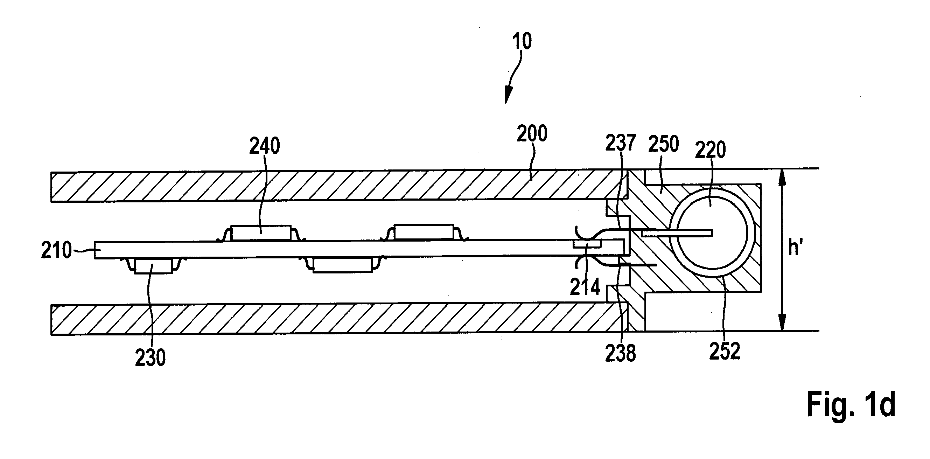

In Figur 1d ist ein Einschubgehäuse dargestellt, das ebenfalls im Wesentlichen dem aus Figur 1b entspricht. Gleiche Bauteile sind mit gleichen Bezugszeichen versehen. Im Unterschied zu Figur 1b ist in diesem Beispiel in dem Abschlusselement 250 ein Stanzgitter 237 angeordnet, auf dem der Kondensator 220 befestigt und kontaktiert ist, beispielsweise durch Schweißen oder Löten. Das Stanzgitter 237 bildet eine Direktsteckverbindung zur Leiterplatte aus. Die Leiterplatte besitzt dazu an ihrem dem Abschlusselement 250 zugewandten Randbereich Kontaktstellen 214, sogenannte Land-Bereiche. Das Stanzgitter 237 weist Federkontakte 238, auf, die die Kontaktbereiche 214 auf der Leiterplatte 210 elektrisch kontaktieren, sobald das Abschlusselement 250 auf die Leiterplatte 210 aufgesteckt wird. Alternativ zu dem Stanzgitter 237 können auch Drahtkontakte, metallisierte Kunststoffteile oder Leiterplatten verwendet werden.

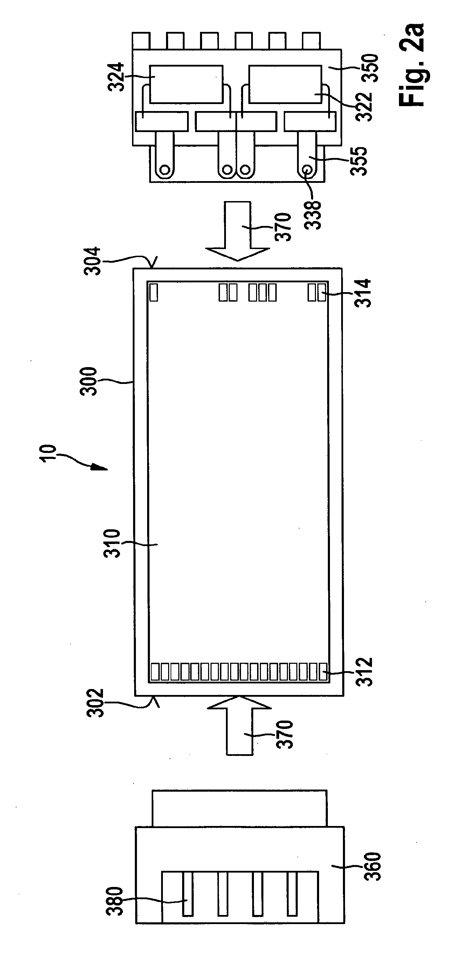

In Figur 2a ist ebenfalls ein Einschubgehäuse 300 dargestellt. Das Gehäuse ist kastenförmig aufgebaut und weist zwei offene Stirnflächen 302 und 304 auf. In dem Gehäuse 300 ist eine Leiterplatte 310 angeordnet, die mit nicht dargestellten elektrischen und/oder elektronischen Bauteilen bestückt ist. An ihren den offenen Stirnflächen 302 und 304 des Gehäuses 300 zugewandten Randbereichen weist die Leiterplatte 310 Kontaktzonen 314 und 312, sogenannte Land-Bereiche, auf. Das Gehäuse 300 wird durch zwei Abschlusselemente 350 und 360 verschlossen, die jeweils in die offenen Stirnflächen 302 und 304 eingeschoben werden, wie durch die Pfeile 370 angedeutet ist, und das Gehäuse 300 nach außen verschließen. In dem Abschlusselement 350 sind erfindungsgemäß elektrische und/oder elektronische Bauteile, in diesem Beispiel zwei Kondensatoren 322 und 324 angeordnet. Die Längsachsen der Kondensatoren 322 und 324 sind parallel zur Ebene der Leiterplatte 310 ausgerichtet. Die elektrische Kontaktierung der Kondensatoren 322 und 324 mit der Leiterplatte 310 erfolgt über eine Direktsteckverbindung, wobei in dem Abschlusselement 350 ein Stanzgitter 355 mit entsprechenden Federkontakten 338 angeordnet ist. Die Kondensatoren 322 und 324 sind mit dem Stanzgitter 355 verbunden. Das Stanzgitter wirkt mit entsprechenden Kontaktbereichen 314 auf der Leiterplatte 310 zusammen und stellt so den elektrischen Kontakt zwischen der Leiterplatte 310 und den Bauteilen 322 und 324 her. Alternativ zu dem Stanzgitter 355 können auch Drahtkontakte verwendet werden. An dem Abschlusselement 350 sind Kühlstrukturen 354 angeordnet, die die Entwärmung der in dem Abschlusselement 350 angeordneten Bauteile 322 und 324 sicherstellen. Die Kühlstrukturen 354 sind beispielsweise als Kühlrippen ausgeführt. In das zweite Abschlusselement 360 ist ein Stecker 380 integriert, der den elektrischen Kontakt von der Leiterplatte 310 nach außen herstellt. Diese Kontaktierung erfolgt wiederum über eine Direktsteckverbindung.

Alternativ zu der in Figur 2a angedeuteten Montagereihenfolge für ein Steuergerät 10 mit einem Einschubgehäuse 300, bei der zunächst die Leiterplatte 310 in dem Gehäuse 300 angeordnet wird und das Gehäuse 300 anschließend von beiden Seiten durch Abschlusselemente 350 und 360 verschlossen wird, ist es möglich, zunächst die Leiterplatte 310 mit dem Abschlusselement 350 zu verbinden und die Anordnung aus Leiterplatte 310 und Abschlusselement 350 in das Gehäuse 300 einzuschieben. Anschließend wird das Gehäuse 300 von der anderen Seite durch das Abschlusselement 360 verschlossen. Alternativ kann zunächst die Leiterplatte mit dem Abschlusselement 360 verbunden werden, die Anordnung aus Leiterplatte 310 und Abschlusselement 360 in das Gehäuse 300 eingeschoben werden und das Gehäuse 300 anschließend durch das Abschlusselement 350 verschlossen werden.

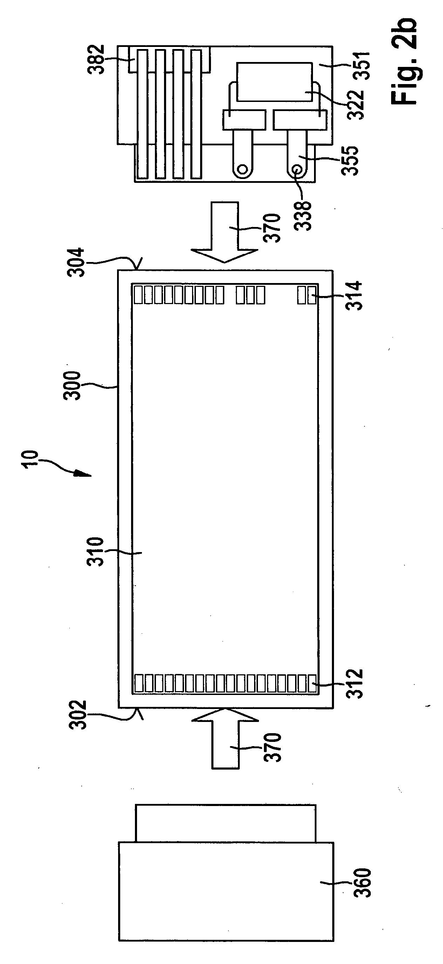

Das in Figur 2b dargestellte Einschubgehäuse entspricht im Wesentlichen dem aus Figur 2a. Gleiche Bauteile sind mit gleichen Bezugszeichen versehen. Im Unterschied zu Figur 2a ist in diesem Beispiel in dem Abschlusselement 351 zusätzlich zu einem elektrischen und/oder elektronischen Bauteil, in diesem Beispiel einem Kondensator 322, ein Steckerelement 382 angeordnet, das die Leiterplatte 310 nach außen kontaktiert.

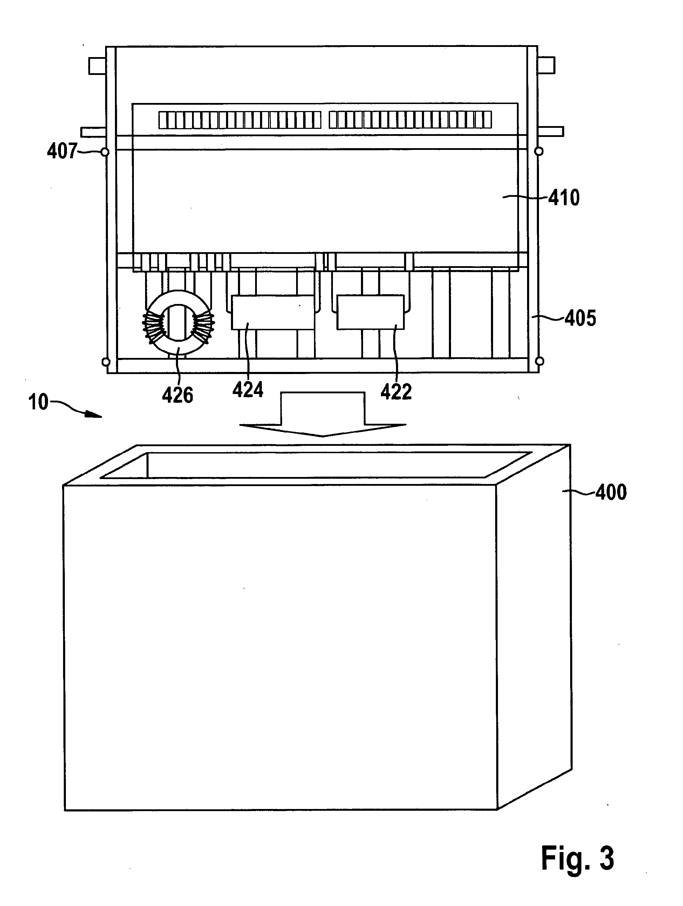

Wie in Figur 3 dargestellt gibt es außerdem die Möglichkeit, eine mit nicht dargestellten elektrischen und/oder elektronischen Bauteilen bestückte Leiterplatte 410, sowie separate Bauteile 422, 424 und 426 in einem Rahmen 405 anzuordnen, der aus Metall oder Kunststoff bestehen kann. Der Rahmen dient als Abschlusselement 450 und wird, wie durch den Pfeil 470 angedeutet in ein Einschubgehäuse 400 eingeschoben. Gleichzeitig dient der Rahmen zur Halterung und Fixierung der Leiterplatte 410 in dem Gehäuse 400. Bei den separat von der Leiterplatte 410 in dem Abschlusselement 450 angeordneten Bauteilen handelt es sich in diesem Beispiel um zwei Kondensatoren 422 und 424, sowie um eine Spule 426, wobei diese so angeordnet sind, dass ihre jeweilige Längsache parallel zur Ebene der Leiterplatte 410 verläuft. An dem Rahmen 405 sind umlaufende Dichtelemente 407 angeordnet, die das Gehäuse 400 nach außen gegen Feuchtigkeit und eindringenden Schmutz abdichten.

## Patentansprüche

1. Elektronisches Steuergerät (10) für Kraftfahrzeuge, umfassend ein röhrenartiges Gehäuse (200,300,400) mit zumindest einer offenen Stirnfläche (102, 104)" eine mit elektrischen und/oder elektronischen Bauteilen (230, 240) bestückte Leiterplatte (210, 310, 410), die durch eine Stirnfläche (102, 104, 302, 304) in das Gehäuse (200, 300, 400) eingeschoben ist, wobei eine offene Stirnfläche (102, 104, 302, 304) durch ein Abschlusselement (250, 350, 360, 450) verschlossen ist, **dadurch gekennzeichnet, dass** das Abschlusselement (250, 350, 360, 450) eine mechanische Halterung (252, 405) für mindestens ein elektrisches und/oder elektronisches Bauteil (220, 422, 424, 426) aufweist, in der das elektrische und/oder elektronisches Bauteil (220, 422, 424, 426) so angeordnet ist, dass seine Längsachse parallel zur Ebene der Leiterplatte (210, 310, 410) verläuft, und dass das Abschlusselement (250, 350, 360) mindestens ein Kontaktierungselement (237,355) zur elektrischen Kontaktierung der in dem Abschlusselement (250, 350, 360, 450) angeordneten elektrischen und/oder elektronischen Bauteilen (220, 322, 324, 422, 424, 426) mit der Leiterplatte (210, 310, 410) aufweist.

2. Elektronisches Steuergerät (10) nach Anspruch 1, **dadurch gekennzeichnet, dass** mindestens ein im Abschlusselement (250, 350, 351) angeordnetes elektrisches oder elektronisches Bauelement (220, 322, 324) mit einem Stanzgitter (237, 355) elektrisch leitend verbunden ist und das Stanzgitter (237, 355) über eine Direktsteckverbindung mit der Leiterplatte (210, 310) kontaktiert ist.

3. Elektronisches Steuergerät (10) nach einem der Ansprüche 1 oder 2, **dadurch gekennzeichnet, dass** ein Kühlelement (354) innen oder außen an dem Abschlusselement (350) angeordnet ist.

4. Elektronisches Steuergerät (10) nach einem der Ansprüche 1 bis 3, **dadurch gekennzeichnet, dass** an dem Abschlusselement (351) mindestens ein Stecker (382) angeordnet ist, der, insbesondere über eine Direktsteckverbindung, mit einer im Gehäuse angeordneten Leiterplatte (310) kontaktiert ist.

5. Elektronisches Steuergerät (10) nach einem der Ansprüche 1 bis 4, **dadurch gekennzeichnet, dass** an dem Abschlusselement (450) ein Rahmen (405) angeordnet ist, der in das Gehäuse (400) reicht und zur Halterung der im Gehäuse (400) und/oder in dem Abschlusselement (450) befindlichen Teile, insbesondere der in dem Abschlusselement angeordneten elektrischen und/oder elektronischen Bauteile (422, 424, 426) und/oder der Leiterplatte (410) dient.

## Claims

1. Electronic control unit (10) for motor vehicles, comprising a tubular housing (200, 300, 400), having at least one open end face (102, 104), a printed circuit board (210, 310, 410) which is equipped with electrical and/or electronic components (230, 240) and which is inserted into the housing (200, 300, 400) through an end face (102, 104, 302, 304), wherein an open end face (102, 104, 302, 304) is closed off by an end element (250, 350, 360, 450), **characterized in that** the end element (250, 350, 360, 450) has a mechanical securing means (252, 405) for at least one electrical and/or electronic component (220, 422, 424, 426) in which the electrical and/or electronic component (220, 422, 424, 426) is arranged in such a way that its longitudinal axis runs parallel to the plane of the printed circuit board (210, 310, 410), and **in that** the end element (250, 350, 360) has at least one contact-forming element (237, 355) for forming electrical contact between the electrical and/or electronic components (220, 322, 324, 422, 424, 426), arranged in the end element (250, 350, 360, 450), and the printed circuit board (210, 310, 410).

2. Electronic control unit (10) according to Claim 1, **characterized in that** at least one electrical or electronic component (220, 322, 324) which is arranged in the end element (250, 350, 351) is connected in an electrically conductive fashion to a punched grating (237, 355), and the punched grating (237, 355) is placed in electrical contact with the printed circuit board (210, 310) via a direct plug-type connection.

3. Electronic control unit (10) according to one of Claims 1 or 2, **characterized in that** a cooling element (354) is arranged inside or outside the end element (350).

4. Electronic control unit (10) according to one of Claims 1 to 3, **characterized in that** at least one plug (382) is arranged on the end element (351), which plug (382) is placed in electrical contact, in particular via a direct plug-type connection, to a printed circuit board (310) arranged in the housing.

5. Electronic control unit (10) according to one of Claims 1 to 4, **characterized in that** a frame (405) is arranged on the end element (450), which frame (405) extends into the housing (400) and serves to secure the parts which are located in the housing (400) and/or in the end element (450), in particular the electrical and/or electronic components (422, 424, 426), arranged in the end element, and/or the printed circuit board (410).

## Revendications

1. Appareil de commande électronique (10) pour véhicules automobiles, comprenant un boîtier de type tubulaire (200, 300, 400) avec au moins une face frontale ouverte (102, 104), une carte à circuits imprimés (210, 310, 410) munie de composants électriques et/ou électroniques (230, 240), laquelle est insérée à travers une face frontale (102, 104, 302, 304) dans le boîtier (200, 300, 400), une face frontale ouverte (102, 104, 302, 304) étant fermée par un élément de terminaison (250, 350, 360, 450),
**caractérisé en ce que** l'élément de terminaison (250, 350, 360, 450) présente une fixation mécanique (252, 405) pour au moins un composant électrique et/ou électronique (220, 422, 424, 426) dans laquelle fixation le composant électrique et/ou électronique (220, 422, 424, 426) est disposé de telle sorte que son axe longitudinal s'étende parallèlement au plan de la carte à circuits imprimés (210, 310, 410), et **en ce que** l'élément de terminaison (250, 350, 360) présente au moins un élément de contact (237, 355) pour le contact électrique des composants électriques et/ou électroniques (220, 322, 324, 422, 424, 426) disposés dans l'élément de terminaison (250, 350, 360, 450) avec la carte à circuits imprimés (210, 310, 410).

2. Appareil de commande électronique (10) selon la revendication 1, **caractérisé en ce qu'**au moins un composant électrique ou électronique (220, 322, 324) disposé dans l'élément de terminaison (250, 350, 351) est connecté de manière électriquement conductrice à une grille estampée (237, 355) et la grille estampée (237, 355) est amenée en contact avec la carte à circuits imprimés (210, 310) par le biais d'une connexion à enfichage direct.

3. Appareil de commande électronique (10) selon l'une quelconque des revendications 1 ou 2, **caractérisé en ce qu'**un élément de refroidissement (354) est disposé à l'intérieur ou l'extérieur sur l'élément de terminaison (350).

4. Appareil de commande électronique (10) selon l'une quelconque des revendications 1 à 3, **caractérisé en ce qu'**au moins un connecteur enfichable (382) est disposé sur l'élément de terminaison (351), lequel, notamment par le biais d'une connexion à enfichage direct, est amené en contact avec une carte à circuits imprimés (310) disposée dans le boîtier.

5. Appareil de commande électronique (10) selon l'une quelconque des revendications 1 à 4, **caractérisé en ce qu'**un cadre (405) est disposé sur l'élément de terminaison (450), lequel cadre s'étend dans le boîtier (400) et sert à retenir les pièces se trouvant dans le boîtier (400) et/ou dans l'élément de terminaison (450), en particulier les composants électriques et/ou électroniques (422, 424, 426) disposés dans l'élément de terminaison et/ou la carte à circuits imprimés (410).
